**Europäisches Patentamt**

**European Patent Office**

**Office européen des brevets**

(19)

(11) Numéro de publication: **0 094 716**

**B1**

(12) # FASCICULE DE BREVET EUROPÉEN

(45) Date de publication du fascicule du brevet:
**14.01.87**

(51) Int. Cl.⁴: **H 01 L 21/60**, G 06 K 19/06

(21) Numéro de dépôt: **83200661.3**

(22) Date de dépôt: **06.05.83**

(54) **Procédé pour connecter un semi-conducteur à des éléments d'un support, notamment d'une carte portative.**

(30) Priorité: **14.05.82 FR 8208430**

(43) Date de publication de la demande:
**23.11.83 Bulletin 83/47**

(45) Mention de la délivrance du brevet:
**14.01.87 Bulletin 87/3**

(84) Etats contractants désignés:
**CH DE FR GB IT LI SE**

(56) Documents cité:
**WO-A-82/00938**
**DE-A-2 810 054**
**FR-A-2 168 507**
**GB-A-1 565 207**

**ELECTRONIQUE INDUSTRIELLE, no. 15, 1 mai 1981,
pages 87-88, Paris, FR. "Carte de paiement
électronique: la version du LEP"**

(73) Titulaire: **RTC- COMPELEC, 130, Avenue Ledru-
Rollin, F-75011 Paris (FR)**
(84) Etats contractants désignés: **FR**

(73) Titulaire: **N.V. Philips' Gloeilampenfabrieken,
Groenewoudseweg 1, NL- 5621 BA Eindhoven (NL)**
(84) Etats contractants désignés: **CH DE GB IT LI SE**

(72) Inventeur: **Jourdain, Philippe, SPID 209 rue de
l'Université, F-75007 Paris (FR)**
Inventeur: **Parmentier, Paul, SPID 209 rue de
l'Université, F-75007 Paris (FR)**

(74) Mandataire: **Caron, Jean, SOCIETE CIVILE S.P.I.D.
209, rue de l'Université, F-75007 Paris (FR)**

## Description

L'invention concerne un procédé pour réaliser une connexion électrique entre des métallisations d'une pastille de circuit à semiconducteur et des pistes conductrices, éventuellement métalliques, portées par une première face d'un support mince, selon lequel on réalise dans le support mince des trous avec une configuration correspondant à celle des métallisations sur la pastille, et, la seconde face dudit support mince étant entièrement isolante, on applique la pastille sur cette seconde face avec ses métallisations tournées vers cette seconde face, en correspondance avec lesdits trous.

Le procédé selon l'invention s'applique avantageusement à la réalisation d'une carte portative contenant un circuit à semiconducteur, notamment une carte de paiement ou une carte d'identité, offrant des éléments conducteurs plats, constitués d'une pâte conductrice, reliés aux bornes du circuit à semiconducteur pour permettre une connexion électrique avec un organe extérieur, et dans le matériau de laquelle on inclut directement le circuit à semiconducteur sous forme d'une pastille semiconductrice dont les bornes sont constituées par des métallisations.

Les supports minces utilisés dans l'invention sont employés dans l'industrie électronique pour reporter une pastille de semiconducteur sur un circuit électronique complexe, en assurant la tenue mécanique en même temps que l'interconnexion électrique de la pastille.

Par les mots "pastille de circuit à semiconducteur" ou sous forme abrégée "pastille semiconductrice", on entend ici un des éléments obtenus par découpe de tranches de matériau semiconducteur, sur lesquelles ont été réalisés des circuits intégrés (ces éléments sont couramment désignés dans le jargon de l'homme du métier sous l'appellation de "puces").

Une solution pour reporter une pastille dans un circuit consiste à utiliser un film que l'on conserve dans le produit fini, et qui procure un isolement vis-à-vis des bords de la pastille de par sa situation entre le ruban ou piste conductrice situé sur une des faces, et la pastille située de l'autre côté. Une telle solution est décrite par un article de la revue "Electronique Industrielle", du 1er mai 1981, pages 87-88. Elle utilise un support en polyimide de 25 microns dont les pistes conductrices sont connectées par des trous métallisés à d'autres pistes conductrices situées sur l'autre face, elles-mêmes soudées aux métallisations de la pastille.

Cette solution, excellente au demeurant sur le plan technique, est toutefois coûteuse à cause de l'utilisation de deux faces métallisées, nécessitant deux étapes de gravure, et la réalisation de trous métallisés.

Une autre solution est divulguée par le brevet DE-A-2 810 054. Ce document décrit un dispositif dans lequel une pastille est fixée et connectée à un support muni de pistes conductrices, le support étant percé de trous selon une configuration correspondant à celle des métallisations de la pastille. Le support est muni d'une couche de fixation sur une de ses faces; il est d'abord creusé de trous par attaque chimique pour obtenir des parois de trou inclinées, puis la couche de fixation est percée par attsque plasma, ensuite la pastille est pressée à chaud (300 à 350°) sur la couche de fixation, après quoi une métallisation est déposée et pénètre dans les trous coniques. Ce procédé comporte donc un grand nombre d'étapes et est relativement coûteux à mettre en oeuvre.

Le but essentiel de la présente invention est de procurer un proc51dé selon lequel des dispositifs de qualité peuvent être obtenus pour un prix de revient extrêmement bas. Du fait de ce bas prix de revient, le procédé peut être appliqué à la réalisation de dispositifs à grande diffusion tels que des cartes portatives, du genre carte de paiement ou carte d'identité. Il peut aussi être appliqué à des supports de montage de circuits intégrés utilisables dans des ensembles économiques, et plus particulièrement quand un encombrement réduit est requis, comme par exemple dans les montres ou les calculatrices de poche.

Le concept inventif général de l'invention résulte de l'idée qu'il est possible d'établir un contact électrique entre une métallisation de la pastille et une piste conductrice située sur l'autre face du support mince, en remplissant le trou avec une pâte conductice qui déborde sur la piste conductrice. Ou côté de la pastille, au contraire, la pâte ne peut déborder du trou puisque la pastille est appliquée contre le support. Ceci est un des avantages notables de l'invention par rapport à certaines solutions classiques, telles que le report de pastilles "face en-dessous", avec contacts collés. Ainsi, le procédé selon l'invention est notamment remarquable en ce que le support étant préalablement muni, de façon connue, de pistes conductrices, disposées de façon à comporter des portions en bordure desdits trous, on maintient la pastille et le support appliqués l'un contre l'autre pendant qu'on dépose, à partir de la première face, un îlot de pâte conductrice sur chaque trou de façon à recouvrir à la fois la métallisation et la piste conductrice.

L'avantage de cette solution est qu'elle part d'un support qui ne comporte des métallisations que d'un côté, et qui est donc courant et bon marché, en permettant pourtant une isolation entre les pistes conductrices et le bord de la pastille.

En allant plus loin dans cette voie, on peut en outre réaliser lesdites pistes conductrices avec la même matière conductrice que celle déposée dans les trous, et en une seule opération.

Ainsi, dans une variante encore plus économique, le procédé selon l'invention est notamment remarquable en ce que, ledit support mince étant au départ entièrement isolant, on maintient la pastille appliquée sur une face du support pendant qu'on constitue les pistes sur la face opposée à celle portant la pastille au moyen d'une pâte conductrice en leur donnent une configuration telle que des portions de pistes recouvrent les trous afin que la pâte y pénètre, venant ainsi en contact avec les métallisations de la pastille.

Ce procédé est d'une simplicité idéale, et peut s'appliquer à un support non métallisé au préalable. Il est donc particulièrement économique.

Certes il a déjà été proposé par le brevet GB-A-1 565 207 de remplacer la soudure utilisée habituellement pour l'assemblage des composants sur les circuits imprimés par un matériau élastomère conducteur, mais ce document concerne le report de composants à fils de connexion, les fils traversant les trous d'un circuit imprimé pour être connectés de façon habituelle sur la face du support qui porte les pistes conductrices, et il exclut la présence d'un composant lorsque le matériau remplit un trou.

Le procédé selon l'invention est utilisé d'une manière avantageuse pour réaliser une carte portative offrant des éléments conducteurs plats reliés aux bornes d'un circuit à semiconducteur inclus directement sous forme de pastille dans le matériau de la carte, et est alors notamment remarquable en ce qu'on place ladite pastille très près d'une face de la carte avec ses métallisations tournées vers ladite face, en constituant ainsi une paroi mince en face de la pastille en ce qu'on ménage des trous dans cette paroi mince, en regard des métallisations de la pastille, et en ce qu'enfin, en même temps que l'on constitue les susdits éléments conducteurs plats, on fait s'étendre la pâte conductrice depuis chaque élément conducteur jusqu'à la métallisation afférente de la pastille, en la faisant pénétrer dans les trous.

Avec ce procédé, la carte constitue par elle-même le susdit "support mince", ce qui procure une simplicité de construction remarquable et un prix de revient particulièrement bas.

La description qui va suivre, en regard des dessins annexés décrivant des exemples non limitatifs, fera bien comprendre comment l'invention peut être réalisée.

La figure 1 représente une coupe d'un support mince, sous lequel on a placé une pastille de circuit à semiconducteur avant le dépôt de matière conductrice.

La figure 2 représente une coupe du même dispositif que la figure 1, mais après le dépôt de matière conductrice.

La figure 3 représente leux fragments de pastille semiconductrice portant chacun une portion de fil métallique.

La figur 4 représente en coupe un dispositif analogue à celui de la figure 2, obtenu par une variante du procédé selon l'invention.

La figure 5 représente en coupe une carte portative obtenue par le procédé selon l'invention.

Les figures 6 et 7 représentent en perspective des exemples de dispositifs obtenus par le procédé selon l'invention.

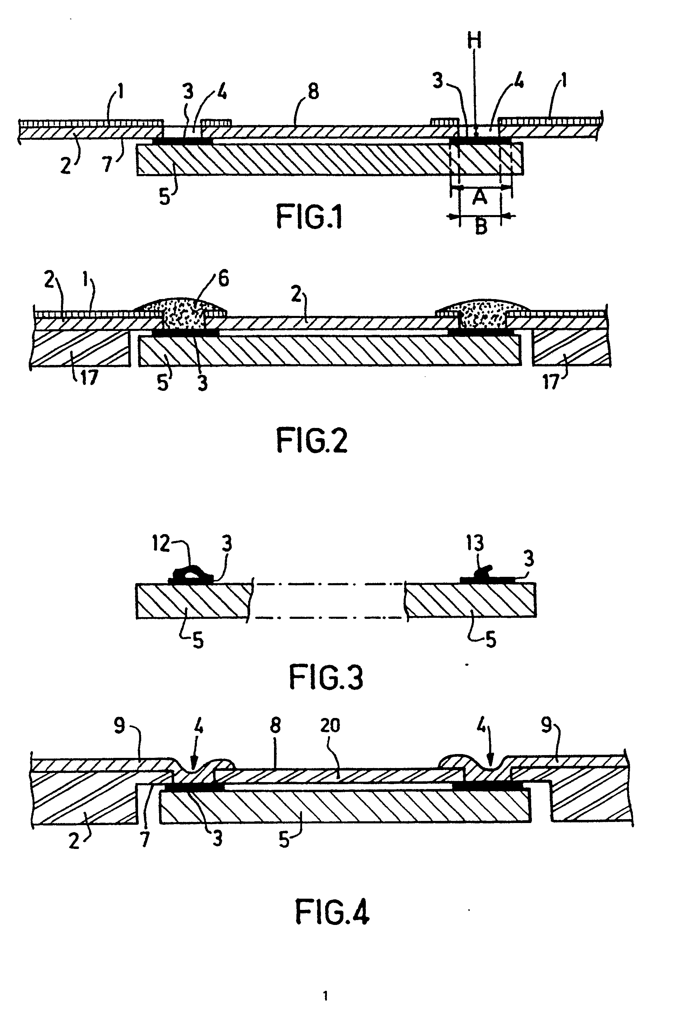

La figure 1 représente une pastille de circuit à semiconducteur 5, munie de métallisations 3, et un support mince 2 muni de pistes conductrices métalliques 1 portées par une première face 8 de ce support mince. Dans ce support, sont réalisés des trous 4 avec une configuration correspondant à celle des métallisations 3 sur la pastille.

Les trous dans le support sont disposés de telle façon qu'en appliquant la pastille contre le support avec un positionnement adéquat, on ait un trou du support en face de chaque métallisation de la pastille.

Les pistes conductrices 1 sont disposées de façon à comporter des portions en bordure des trous. De preférence, ces portions en bordure des trous sont constituées par des anneaux entourant les trous, appelés habituellement lunules. Le support et les pistes sont constitués par un classique circuit imprimé mince, dit "simple face", sur lequel on monte un grand nombre de pastilles, et que l'on découpe en petits morceaux contenant chacun soit une pastille, soit plusieurs pastilles interconnectées.

Le support peut également être constitué par un film en forme de ruban éventuellement muni de trous de positionnement et portant des pistes métalliques déposées sur une de ses faces. Ce film, muni de pastilles par le procédé de l'invention, et enroulé sur une bobine, est utilisé dans une machine qui le découpe et reporte sur des circuits électroniques des portions de film munies chacune d'une pastille.

Afin d'assurer une mise en oeuvre efficace du procédé selon l'invention, il importe que certaines proportions dimensionnelles soient respectées. En particulier, il convient que l'épaisseur H du support soit relativement faible devant la dimension des trous, celle-ci étant du même ordre de grandeur que celle des métallisations: on emploie de préférence une épaisseur H inférieure à 0,3 mm.

En utilisant une technologie classique de circuit imprimé pour réaliser le support 2, par exemple en verre époxy, on est capable, d'une façon courante, de réaliser des trous ronds de diamètre B = 0,4 mm. L'épaisseur H étant égale, par exemple à 0,1 mm, on a ainsi un trou quatre fois plus large que sa profondeur.

Les métallisations 3 de la pastille sont un peu plus grandes. Par exemple, elles peuvent avoir une largeur A de 0,5 mm. Ceci est une dimension notablement plus grande qu'il est d'usage en matière de circuits intégrés. Il faut bien voir que l'invention s'applique de préférence à des circuits intégrés présentant une grande complexité, mais comportant malgré cela un nombre réduit de métallisations d'entrée/sortie. C'est le cas, par exemple, des circuits utilisés pour les cartes de paiement, qui offrent des fonctions logiques multiples et complexes et ne comportent que huit ou même seulement six bornes. Supposons par exemple qu'une pastille portant un tel circuit ait une surface de 15 mm2 avec six métallisations de 0,1 mm x 0,1 mm. Si on porte à 0,5 x 0,5 mm la dimension de ses métallisations, on accroît de 1,44 mm² la surface, soit à peine 10 % de la surface totale de la pastille. On accroît d'à peu près autant le prix d'une pastille, mais le gain réalisé grâce à la simplification du montage est supérieur à l'augmentation de prix de la pastille, et finalement le produit revient moins cher.

Il est possible également de réaliser des trous plus petits, grâce à l'emploi d'un laser. Pour garder cependant une tolérance de positionnement raisonnable, ainsi qu'un rapport B/H suffisant, il est toujours avantageux, là encore, d'utiliser des métallisations un peu plus grandes qu'il est d'usage. On pourra par exemple réaliser des trous B = 0,2 mm et utiliser des métallisations avec A = 0,3 mm, l'épaisseur H étant toujours de 0,1 mm. Dans l'exemple cidessus, cela correspondrait à une augmentation de surface de la pastille de seulement 3,2 %.

A partir d'un tel support et d'une telle pastille, et la seconde face 7 du support mince, opposée à celle 8 qui porte les métallisations, étant entièrement isolante, on place la pastille 5 sur cette seconde face 7 avec ses métallisations 3 tournées vers cette seconde face et en correspondance avec les trous 4 et, ainsi que le représente la figure 2, on dépose à partir de la première face 8 un îlot de pâte conductrice polymérisable 6 sur chaque trou de façon à recouvrir à la fois la métallisation placée sous le trou et la piste conductrice 1 en bordure dudit trou.

Cette pâte est alors amenée de préférence en utilisant un écran ou un pochoir et une raclette. L'écran est par exemple constitué d'un tissu recouvert d'un enduit photogravé dans le procédé bien connu dit: de sérigraphie. Dans ce cas, la pastille et le support sont maintenus en place pendant le dépôt de la pâte par un moyen mécanique connu, par exemple une plaque munie de trous et une aspiration, à la suite de quoi la viscosité et l'adhérence de la pâte sont suffisantes pour maintenir la pastille pendant les manipulations subséquentes jusqu'à ce qu'on ait assuré la polymérisation de la pâte, par exemple par chauffage dans un four.

Dans ce cas, les métallisations de la pastille sont de préférence constituées d'un empilage titane/platine/or qui donne de bons résultats avec la plupart des pâtes conductrices du commerce.

La pastille peut aussi être maintenue grâce à une cale 17, d'épaisseur égale à, ou légèrement plus faible que celle de la pastille 5.

Une paroi non représentée est fixée à la face intérieure du dispositif et maintient la pastille en place, au moins pendant le dépôt et, éventuellement, la polymérisation de la matière conductrice 6. Cette paroi peut, par exemple, être faite d'un ruban adhésif.

La pastille peut également être maintenue par un cordon de matière adéquate déposée le long du périmètre de la pastille, entre cette dernière et la cale 17. Une telle matière peut être une pâte isolante polymérisable ou un verre fusible à basse température. Cette disposition a l'avantage de procurer ultérieurement une protection climatique de la pastille.

La cale 17 peut être collée sur le support 2, par exemple selon un procédé connu de pressage des circuits imprimés multicouches.

Au lieu d'un support mince plat 2 et d'une cale 17, on peut aussi utiliser, ainsi que le représente la figure 4, un support d'un seul tenant 2 dans lequel on creuse un évidement pour loger la pastille 5. Cet évidement ne débouche pas et laisse une paroi 20 constituant le support mince proprement dit. Ce support est meilleur marché que celui de la figure 2 car il n'utilise qu'une seule feuille et on évite un pressage.

Ce support peut aussi être réalisé en céramique, ce qui présente plusieurs avantages: l'évidement peut alors être obtenu, de même que les trous, directement par moulage, et on peut utiliser, pour assurer la meilleure étanchéité possible le long du périmétre de la pastille, un verre fusible à une température pouvant atteindre 300 à 400° C, les divers coefficients de dilatation (silicium, verre, céramique) étant bien accordés.

En perfectionnant encore l'idée de l'invention, on utilise un support entièrement isolant, tel que représenté en 2 sur la figure 4, on place la pastille 5 sur une face 7 de ce support, avec ses métallisations 3 tournées vers cette face et en correspondance avec les trous 4, et on constitue alors les pistes 9 sur l'autre face au moyen d'une pâte conductrice, en leur donnant une configuration telle que des portions de pistes recouvrent les trous 4 afin que la pâte y pénètre, venant ainsi en contact avec les métallisations 3 de la pastille. Ces pistes 9 sont de préférence déposées au moyen d'une sérigraphie.

Bien entendu c'est tout à fait par hasard que l'on a représenté la piste 9 sur un support d'une seule pièce 2, alors que sur la figure 2 on a représenté une piste préexistante 1 sur un support 2, 7 constitué de deux feuilles superposées. Il va de soi que chacun des deux types de support peut être utilisé indifféremment avec chacun des types de pistes conductrices.

La figure 3 représente des portions de pastille 5 avec des métallisations 3. Sur chaque métallisation on a soudé, avant la découpe des tranches de matériau semiconducteur fournissant les pastilles, une portion de fil métallique. A gauche de la figure, un fil 12 a été soudé en deux points voisins sur la même métallisation en formant ainsi une sorte d'anse de panier qui améliore l'accrochage du matériau conducteur à la métallisation. Il faut bien voir cependant, que ces dispositions seulement destinées à obtenir un meilleur rendement et une meilleure fiabilité, ne sont pas indispensable pour la mise en oeuvre de l'invention.

Dans le cas ou le produit à réaliser est une carte électronique portative, ainsi qu'il a été indiqué en préambule, on peut avantageusement, au lieu d'inclure un support dans la carte, réaliser celle ci de telle façon qu'elle constitue elle même directement le support de la pastille de circuit intégré.

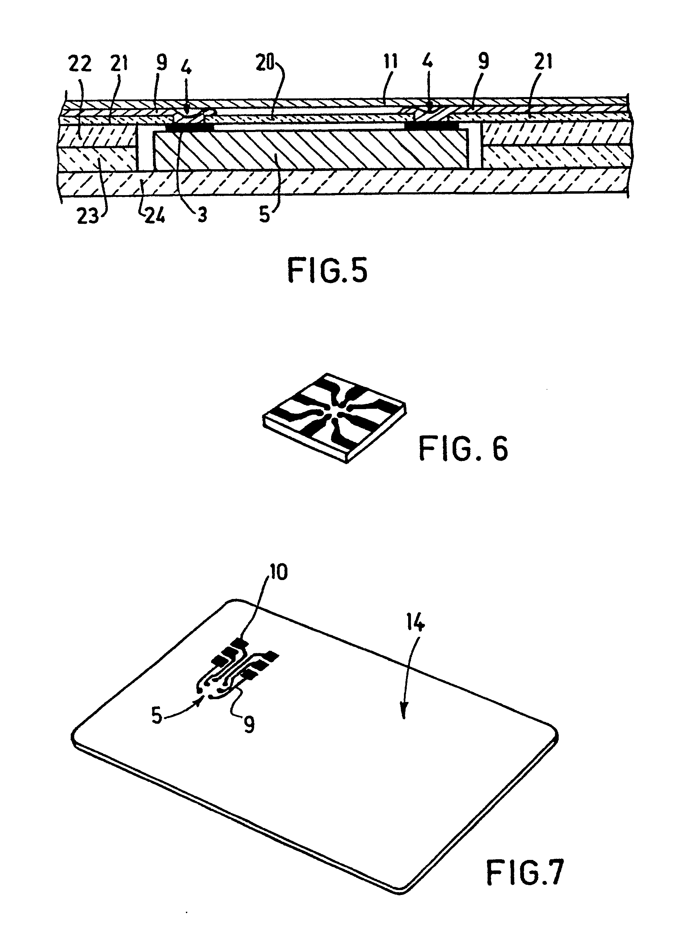

Une telle carte offre des éléments conducteurs plats (10, figure 7) qui servent à établir des contacts électriques avec un appareil au moyen duquel la carte est exploitée. Ces éléments conducteurs plats peuvent être réalisés au moyen d'une pâte conductrice, et doivent être réunis aux bornes du circuit à semiconducteur inclus directement dans la carte.

La figure 5 représente des feuilles empilées 21, 22, 23, 24. Les feuilles centrales 22, 23 ont une épaisseur sensiblement égale à celle de la pastille 5. Les deux couches externes 21 et 24 permettent d'enfermer la pastille 5 dans l'ensemble. Une fois cet empilage pressé à chaud avec la pastille 5 à l'intérieur, celle ci se trouve placée très près d'une face de la carte, ici la face supérieure, avec ses métallisations 3 tournées vers ladite face. On a donc constitué une paroi mince 20 en face de la pastille. On a ménagé des trous 4 dans cette paroi mince, préalablement au pressage de l'empilage, et placé la feuille 21 de telle façon que ces trous soient en regard des métallisations 3 de la pastille. Les feuilles 21 à 24 constituant la carte peuvent être en chlorure de polyvinyle dit PVC, et pressées selon la technique habituelle de fabrication des cartes portatives à pistes magnétiques. Elles peuvent aussi être en laminé de fibre de verre et époxy, telles qu'on en utilise pour réaliser les circuits imprimés multicouches, et pressées selon la technique connue de ces circuits. On peut aussi réaliser l'ensemble correspondant aux feuilles 21, 22, 23 d'un seul tenant, par exemple en le moulant avec une des nombreuses matières susceptibles d'être moulées par transfert. Les trous 4 viendront alors de moulage. La pastille 5 sera alors mise en place, par exemple collée sur la feuille 24, et celle ci à son tour collée sur l'ensemble 21, 22, 23.

Une fois constitué l'ensemble avec la pastille à l'intérieur, on constitue les susdits éléments conducteurs plats par sérigraphie d'une pâte conductrice à basse température de polymérisation, et en même temps que l'on constitue ces éléments, on fait s'étendre la pâte conductrice depuis chaque éléments jusqu'à la métallisation afférente de la pastille, en la faisant pénétrer dans les trous: ainsi le dessin des conducteurs formés au moyen de sérigraphie est tel qu'un motif unique constitue un susdit élément conducteur plat et une piste conductrice le reliant à la pastille de circuit intégré, et que chaque piste recouvre un trou de façon que sa matière y pénètre et fasse contact avec une métallisation de la pastille.

Une feuille protectrice 11 peut enfin être collée sur l'empilage pour protéger les pistes 9 et les éléments conducteurs plats. Bien entendu, des orifices sont prévus dans cette feuille 11 pour donner accès aux conducteurs plats.

La figure 6 représente un support de circuit intégré réalisé selon le procédé de l'invention et destiné à être utilisé dans un sous-ensemble électronique, ou aussi à être inclus dans une carte portative.

La figure 7 qui représente une carte portative constituant directement le support d'une pastille de circuit intégré permet de bien se rendre compte de la configuration des conducteurs. Les susdits éléments conducteurs plats sont représentés en 10, les pistes en 9. Celles-ci se terminent par des plots arrondis au-dessus de chaque trou pour prendre contact avec la pastille "enterrée" dont la position est indiquée par la flèche 5.

Il va de soi que le procédé selon l'invention gagne à être utilisé dans un processus de fabrication dit "en multiple", c'est-à-dire qu'on fabrique une plaque ou une bande contenant un grand nombre de dispositifs tels que ceux des figures 6 ou 7, et qu'on découpe tout à fait à la fin les plaques ou les bandes pour obtenir des dispositifs individuels.

**Revendications**

1. Procédé pour réaliser une connexion électrique entre des métallisations (3) d'une pastille de circuit à semiconducteur (5) et des pistes cunductrices métalliques (1) portées par une première face (8) d'un support mince (2) selon lequel on réalise dans le support des trous (4) avec une configuration correspondant à celle des métallisations sur la pastille, les pistes conductices étant disposées de façon à comporter des portions en bordure desdits trous, et la seconde face (7) du support mince étant entièrement isolante, on applique la pastille (5) sur cette seconde face avec ses métallisations tournées vers cette seconde face et en correspondance avec lesdits trous, caractérisé en ce qu'on maintient la pastille et le support appliqués l'un contre l'autre pendant qu'on dépose, à partir de la première face, un îlot de pâte-conductrice polymérisable (6) sur chaque trou de façon à recouvrir à la fois la métallisation placée sous le trou et la piste conductrice en burdure dudit trou.

2. Procédé pour réaliser une connexion électrique entre des métallisations d'une pastille (5) de circuit à semiconducteur et des pistes conductrices (9) portées par une face (8) d'un support mince, selon lequel un réalise dans le support mince des trous (4) avec une configuration correspondant à celle des métallisations sur la pastille et on applique la pastille sur une face (7) du support avec ses métallisations tournées vers cette face et en correspondance avec lesdits trous, caractérisé en ce que, ledit support mince étant au départ entièrement isolant, on maintient la pastille et le support appliqués l'un contre l'autre pendant qu'on constitue les pistes sur la face (8) opposée à celle supportant la pastille, au moyen d'une pâte conductrice (9), en leur donnant une configuration telle que des portions de pistes recouvrent les trous afin que la pâte y pénètre, venant ainsi en contact avec les métallisations de la pastille (5).

3. Procédé pour réaliser une carte portative contenant un circuit à semiconducteur, notamment une carte de paiement ou une carte d'identité, offrant des éléments conducteurs plats (10), constitués d'une pâte conductrice, reliés aux bornes du circuit à semiconducteur pour permettre une connexion électrique avec un organe extérieur, selon lequel on inclut directement le circuit à semiconducteur dans le matériau de la carte sous forme d'une pastille (5) semiconductrice dont les bornes sont constituées par des métallisations, caractérisé en ce qu'on place ladite pastille très près d'une face de la carte avec ses métallisations (3) tournée vers ladite face, en constituant ainsi une paroi mince (20) en face de la pastille, en ce qu'on ménage des trous dans cette paroi mince, en regard des métallisations de la pastille, et en ce qu'enfin, en même temps que l'on constitue les susdits éléments conducteurs plats, on fait s'étendre la pâte conductrice (9) depuis chaque élément conducteur jusqu'à la métallisation afférente de la pastille, en la faisant pénétrer dans les trous.

4. Procédé selon l'une quelconque des revendications précédentes, caractérisé en ce qu'on soude préalablement sur chaque métallisation de la pastille une portion (12, 13) de fil métallique.

## Patentansprüche

1. Verfahren zur Herstellung einer elektrischen Verbindung zwischen Metallisierungen (3) eines Halbleiterbausteins (5) und Metall-Leiterbahnen (1) auf einer ersten Oberfläche (8) eines dünnen drägers (2), in dem Löcher (4) mit einer der Konfiguration der Metallisierungen auf dem Halbleitersbaustein entsprechenden Konfiguration angebracht werden, wobei die Leiterbahnen derart angeordnet sind, dass Leiterbahnteile am Rand dieser Löcher liegen, und die Zweite Oberfläche (7) des dünnen Trägers völlig isolierend ist, wobei der Halbleiterbaustein (5) an dieser zweiten Oberfläche angebracht wird, seine Metallisierungen dieser zweiten Oberfläche Zugewandt sind und ihre Lage der Lage der Löcher entspricht, dadurch gekennzeichnet, dass der Halbleiterbaustein und der Träger aneinandergedrückt werden, wenn von der ersten Oberfläche ausgehend eine Insel aus polymerisierbarer Leitpaste (6) in jedem Soch derart angebracht wird, dass sie gleichzeitig die unter dem Loch befindliche Metallisierung und die am Lochrand befindliche Leiterbahn bedeckt.

2. Verfahren zur Herstellung einer elektrischen Verbindung zwischen Metallisierungen (3) eines Halbleiterbausteins (5) und Leiterbahnen (9) auf einer Oberfläche (8) eines dünnen drägers, in dem Löcher (4) mit einer der Konfiguration der Metallisierungen auf dem Halbleiterbaustein entsprechenden Konfiguration angebracht werden, wobei der Halbleiterbaustein (5) an einer Oberfläche (7) des Trägers angebracht wird, seine Metallisierungen dieser Oberfläche zugewandt sind und ihre Lage der Lage der Löcher entspricht, dadurch gekennzeichnet, dass der dünne Träger zunächst völlig isolierend ist, und der Halbleiterbaustein und der Träger aneinandergedrückt werden, wenn auf der Oberfläche (8) die Leiterbahnen gegenüber denen auf dem Halbleiterbaustein mit Hilfe einer Leitpaste (9) gebildet werden, wobei eine Konfiguration erhalten wird, bei der Leiterbahnteile die Löcher bedecken, um die Paste in die Löcher durchdringen und auf diese Weise mit den Metallisierungen des Halbleiterbausteins (5) in Kontakt kommen zu lassen.

3. Verfahren zur Verwirklichung einer tragbaren Karte mit einer Halbleiterschaltung, und insbesondere einer Zahlungskarte oder Identitätskarte, die flache leitende Elemente (10) enthält, die aus einer Leitpaste bestehen und mit Anschlüssen der Halbleiterschaltung zur Ermöglichung einer elektrischen Verbindung mit einem externen Element verbunden ist, wobei die Halbleiterschaltung in das Material der Karte in Form eines Halbleiterbausteins (5) direkt eingeschlossen wird, dessen Anschlüsse durch Metallisierungen gebildet werden, dadurch gekennzeichnet, dass der Halbleitebausteins ganz nahe bei einer Oberfläche der Karte mit seiner Metallisierungen (3) angeordnet wird, die dieser Oberf läche zugewandt sind, wobei so eine dünne Wand (20) vor dem Halbleiterbaustein gebildet wird, dass in dieser dünnen Wand in bezug auf die Metallisierungen des Halbleiterbausteins Löcher angebracht werden, und dass schliesslich gleichzeitig mit der Bildung der genannten flachen Leiterelemente die Leitpaste (8) von jedem Leiterelement bis zur betreffenden Metallisierungen auf dem Halbleiterbaustein ausgebreitet wird, indem die Paste in die Löcher durchdringt.

4. Verfahren nach einem oder mehreren der vorangehenden Ansprüche, dadurch gekennzeichnet, dass zuvor auf jeder Metallisierung des Halbleiterbausteins ein Stück (12, 13) Metalldraht verlötet wird.

## Claims

1. A method of establishing an electrical connection between metallizations (3) of a semiconductor circuit chip (5) and metallic conductor tracks (1) carried by a first surface (8) of a thin support (2), by which holes (4) having a configuration corresponding to that of the metallizations on the chip are provided in the support, the conductor tracks being arranged in such a manner that they comprise parts adjoining the said holes, and the second surface (7) of the thin support being entirely isolating, and the chip (5) is applied to the said second surface with its metallizations facing this second surface and in conformity with the said holes, characterized in that the chip and the support are held so as to be pressed one against the other whilst an island of polymerizable conducting paste (6) is deposited from the first surface on each hole in such a manner that both the metallization provided under the hole and the conducting track adjoining the said hole are covered.

2. A method of establishing an electrical connection between metallizations of a chip (5) of a semiconductor circuit and conducting tracks (9) carried by a surface (8) of a thin support, by which holes (4) having a configuration corresponding to that of the metallizations on the chip are provided in the thin support and the chip is applied to a surface (7) of the support with its metallizations facing this surface and in conformity with the said holes, characterized in that the said thin support being in the beginning entirely isolating, the chip and the support are held so as to be pressed one against the other, whilst the tracks are formed on the surface (8) opposite to that supporting the chip by means of a conducting paste (9) by giving them such a configuration that parts of tracks cover the holes in order that the paste penetrates into them, thus getting into contact with the metallizations of the chip (5).

3. A method of obtaining a portable card containing a semiconductor circuit, more particularly a credit card or an identity card, having flat conducting elements (10) constituted by a conducting paste and connected to the terminals of the semiconductor circuit in order to establish an electrical connection with an external member, by which the semiconductor circuit is directly included in the material of the card in the form of a semiconductor chip (5), whose terminals are constituted by metallizations, characterized in that the said chip is arranged very close to a surface of the card with its metallizations (3) facing the said surface, thus constituting a thin wall (20) opposite to the chip in that holes are provided in this thin wall opposite to the metallizations of the chip, and in that finally simultaneously with the formation of the aforementioned flat conducting elements the conducting paste (8) is caused to extend from each conducting element to the relevant metallization of the chip by causing it to penetrate into the holes.

4. A method as claimed in any one of the preceding Claims, characterized in that previously a part (12, 13) of metal wire is soldered to each metallization of the chip.

FIG.1

FIG.2

FIG.3

FIG.4

FIG.5

FIG. 6

FIG.7